# EUROPÄISCHE PATENTSCHRIFT

(11) **EP 2 087 519 B1**
(45) Veröffentlichungstag und Bekanntmachung des Hinweises auf die Patenterteilung: **29.08.2012**
(21) Anmeldenummer: 07818683.0
(22) Anmeldetag: 04.10.2007
(51) Int. Cl.: H01L 27/28

(54) **FELDEFFEKTTRANSISTOR SOWIE ELEKTRISCHE SCHALTUNG**
FIELD EFFECT TRANSISTOR, AND ELECTRIC CIRCUIT
TRANSISTOR A EFFET DE CHAMP ET CIRCUIT ELECTRIQUE

(30) Priorität: 06.10.2006 DE 102006047388
(43) Veröffentlichungstag der Anmeldung: 12.08.2009
(60) Teilanmeldung: 11006631.3
(73) Patentinhaber: PolyIC GmbH & Co. KG, 90763 Fürth (DE)
(72) Erfinder: ULLMANN, Andreas, 90513 Zirndorf (DE); FIX, Walter, 90763 Fürth (DE)
(74) Vertreter: Zinsinger, Norbert
(86) Internationale Anmeldenummer: PCT/EP2007/008604
(87) Internationale Veröffentlichungsnummer: WO 2008/043475

(56) Entgegenhaltungen:
- EP-A- 1 411 554
- EP-A- 1 519 418
- WO-A-2004/047144
- WO-A-2004/068608
- US-A- 5 323 033
- US-A1- 2005 227 407

## Beschreibung

Die Erfindung betrifft einen Feldeffekttransistor mit mindestens einer Source-Elektrodenschicht und mindestens einer in gleicher Ebene angeordneten Drain-Elektrodenschicht, einer Halbleiterschicht, einer Isolatorschicht sowie einer Gate-Elektrodenschicht. Die Erfindung betrifft weiterhin ein Logikbauelement, elektrische Schaltungen sowie ein Verfahren zur Herstellung elektrischer Schaltungen.

Feldeffekttransistoren mit dem oben genannten Aufbau sind aus der WO 2004/047144 A2 bekannt. Auf einem Substrat sind ineinander greifende Source- und Drain-Elektrodenschichten offenbart, welche in dieser Reihenfolge mit einer strukturierten Halbleiterschicht und einer vollflächigen Isolatorschicht bedeckt sind. Auf der Isolatorschicht befindet sich eine strukturierte Gate-Elektrodenschicht. Zwischen der Source-Elektrodenschicht und der Drain-Elektrodenschicht befindet sich der sogenannte Kanal, über welchem die Gate-Elektrodenschicht, hier als Top-Gate-Elektrode, angeordnet ist. Der Feldeffekttransistor ist in einem preisgünstigen Druckverfahren herstellbar.

Dabei ist die genaue Registrierung bzw. Platzierung der Gate-Elektrodenschicht gegenüber den Source/Drain-Elektrodenschichten erforderlich, da dies die Schaltgeschwindigkeit des Feldeffekttransistors stark beeinflusst. So wurde zur Verbesserung der Registrierung bereits versucht, die Flächenausdehnung der Gate-Elektrodenschicht soweit zu vergrößern, dass diese - senkrecht zur Ebene der Source/Drain-Elektrodenschichten gesehen - das von den Source- und Drain-Elektrodenschichten bedeckte Gebiet sowie das dazwischen eingeschlossene Kanalgebiet komplett überzieht und gegebenenfalls noch darüber hinausragt. Ein derartiger Feldeffekttransistor weist, letztendlich unabhängig von der genauen Anordnung der Gate-Elektrodenschicht gegenüber den Source/Drain-Elektrodenschichten, ein gutes Ein- und Ausschaltverhalten auf. Jedoch entstehen durch die vergrößerte Flächenausdehnung der Gate-Elektrodenschicht hohe Kapazitäten, so genannte Registerkapazitäten, durch welche mit einem derartigen Feldeffekttransistor gebildete Logikbauelemente und elektronische Schaltungen an Schnelligkeit verlieren.

Weiter offenbart die WO 2004/047144 A2 eine elektrische Schaltung umfassend zwei FETs durch Drucken herzustellen.

Weiter beschreibt die EP 1 411 554 A1 einen speziellen Feldeffekttransistor, welcher einen aus Carbon Nanotubes bestehenden Kanal aufweist, zur Erzielung einer höheren Schaltfrequenz als der von Galium-Arsenit-Feldeffekttransistoren. Der zwischen der Source-Elektrode und der Drain-Elektrode ausgebildete Kanal ist aus einem Array von Carbon Nanotubes aufgebaut, die in einem Abstand zwischen 0,3 nm bis zu 10 µm nebeneinander angeordnet sind.

Die EP 1519418 A1 beschreibt eine Halbleiteranordnung, bei der ein leitfähiger Pfad in einem zwei- oder dreidimensionalen Netzwerk durch eine Abfolge von kleinen, elektrisch leitfähigen oder halbleitenden Partikeln und funktionelle Gruppen gebildet wird. Dieser leitfähige Pfad umfasst keinen intermolekularen Elektronentransfer und die Ladungsträgerbeweglichkeit ist so nicht durch einen solchen begrenzt.

Die US 2005/0227407 A1 beschreibt einen organischen Dünnfilmtransistor, bei dem auf ein Substrat zunächst eine Gate-Schicht, sodann eine Isolatorschicht, sodann eine Elektrodenschicht, sodann eine Halbleiterschicht und sodann eine Passivierungsschicht aufgebracht wird, welche sowohl die Halbleiterschicht als auch die Elektrodenschicht bedeckt.

Es ist die Aufgabe der Erfindung, einen verbesserten Feldeffekttransistor mit mindestens einer, mit Hilfe eines Druckverfahrens strukturierten elektrischen Funktionsschicht bereitzustellen.

Diese Aufgabe wird durch ein Verfahren nach Anspruch 1 gelöst.

Obwohl bei der erfindungsgemäßen elektrischen Schaltung auf dem Trägersubstrat Platz für überzählige zweite Bauelemente vorgesehen ist, können dennoch bis zu 50% der Fläche gegenüber herkömmlichen elektrischen Schaltungen eingespart werden, ohne dass es zu einer Beeinträchtigung der wesentlichen Eigenschaften der elektrischen Schaltung kommt, da die einzelnen Bauteile der elektrischen Schaltung deutlich kleiner ausgebildet werden können. Je nach vorhandener Registertoleranz beim Drucken der Leiterbahn wird eines der mindestens zwei zweiten Bauelemente elektrisch leitend an das mindestens eine erste Bauelement angeschlossen.

Die Flächenausdehnung der Gate-Elektrodenschicht ist deutlich kleiner ausgebildet als die Flächenausdehnung der Source- und Drain-Elektrodenschichten und des dazwischen angeordneten Kanalgebiets zusammen. Es ergibt sich ein funktionsfähiger Feldeffekttransistor, der elektrisch einen ähnlichen ON-Strom und ähnlich geringe Kapazitäten aufweist, wie es ein Feldeffekttransistor mit einer genauen Positionierung der Gate-Elektrodenschicht im Register zu den Source/Drain-Elektrodenschichten erreicht, obwohl eine exakte Registrierung nicht vorhanden ist. Zudem wird erreicht, dass trotz des überzähligen Kanalgebiets der Platzbedarf zur Bildung des Feldeffekttransistors bis zu 50% reduziert werden kann, da die Source/Drain-Elektrodenschichten deutlich kleiner ausgebildet sein können.

Besonders bevorzugt ist es, wenn die Flächenausdehnung der Gate-Elektrodenschicht im Hinblick auf die Summe der Flächenausdehnungen der Source/Drain-Elektrodenschichten und des Kanalgebiets um den Betrag der mit dem eingesetzten Druckverfahren maximalen Registertoleranz verkleinert ausgebildet wird. So sind mit den hier bevorzugten Druckverfahren, wie Tiefdruck, Hochdruck, Flachdruck, Durchdruck (Siebdruck oder Schablonendruck) oder Tampondruck, üblicherweise Registertoleranzen im Bereich von 400 bis 40µm erreichbar. Dabei sind sowohl Seitenregistertoleranzen senkrecht zur Druckrichtung wie auch Längsregistertoleranzen in Druckrichtung zu berücksichtigen.

Die Verkleinerung der Flächendimension der Gate-Elektrodenschicht erfolgt vorzugsweise dadurch, dass ihre Länge in Druckrichtung kleiner gewählt wird als die Summe der Längen der Source/Drain-Elektrodenschichten und des Kanalgebiets in Druckrichtung. Die Breite der Gate-Elektrodenschicht senkrecht zur Druckrichtung kann im Hinblick auf die Summe der Breiten der Source/Drain-Elektrodenschichten und des Kanalgebiets senkrecht zur Druckrichtung ebenfalls vermindert ausgebildet werden. Aber auch eine Erhöhung der Breite der Gate-Elektrodenschicht senkrecht zur Druckrichtung gemäß dem oben beschriebenen bekannten Verfahren hat sich in Kombination mit einer Verminderung der Länge der Gate-Elektrodenschicht in Druckrichtung bewährt.

Besonders bewährt hat es sich dabei, wenn sich der Kanal zwischen der mindestens einen Source-Elektrodenschicht und mindestens zwei Drain-Elektrodenschichten erstreckt, wobei die Drain-Elektrodenschichten voneinander elektrisch isoliert ausgebildet sind. Der Leck-Strom des Feldeffekttransistors, welcher in nicht von der Gate-Elektrodenschicht bedeckten/überlagerten Kanalbereichen entsteht, wirkt sich dadurch nicht mehr störend auf die elektrischen Eigenschaften des Feldeffekttransistors aus.

Weiterhin hat es sich als vorteilhaft erwiesen, wenn die mindestens eine Source-Elektrodenschicht kammförmig oder in Form paralleler, elektrisch voneinander isolierter Linien ausgebildet ist. Für die mindestens eine Drain-Elektrodenschicht hat sich ebenfalls eine kammförmige Ausgestaltung oder in Form paralleler, elektrisch voneinander isolierter Linien bewährt. Sind mehrere Drain-Elektrodenschichten vorgesehen, so hat sich eine Ausgestaltung einer jeden Drain-Elektrodenschicht jeweils in Kammform bewährt. Besonders bevorzugt ist eine kammförmige Ausgestaltung der mindestens einen Source-Elektrodenschicht in Kombination mit einer kammförmigen Ausgestaltung der mindestens einen Drain-Elektrodenschicht, wobei die Kammzähne der Source- und Drain-Elektrodenschichten ineinander eingreifen, so dass der Kanal mäanderförmig zwischen der mindestens einen Source-Elektrodenschicht und der mindestens einen Drain-Elektrodenschicht verläuft. Eine Gate-Elektrodenschicht gemäß der Erfindung, welche vorzugsweise mit derart kammförmig ausgebildeten, ineinander greifenden Source- und Drain-Elektrodenschichten überlappend ausgebildet ist, bedeckt das mäanderförmige Kanalgebiet lediglich teilweise, so dass Kanalgebiete, die nicht zur Wirkungsweise des Feldeffekttransistors beitragen, ungenutzt verbleiben. Eine Lageungenauigkeit der Gate-Elektrodenschicht im Bereich des Kanalgebiets aufgrund der beim Drucken unvermeidbaren Registertoleranzen ist für das elektrische Verhalten des Feldeffekttransistors ohne oder nahezu ohne Bedeutung.

Es hat sich bewährt, wenn die Gate-Elektrodenschicht, senkrecht zur Ebene der mindestens einen Source-Elektrodenschicht und der mindestens einen Drain-Elektrodenschicht gesehen, eine Fläche von 10 bis 90% des Kanals bedeckt, insbesondere eine Fläche von 25 bis 50%.

Die Gate-Elektrodenschicht kann als eine Bottom-Gate-Elektrode oder als eine Top-Gate-Elektrode ausgebildet werden. Bei einer Ausführung als Bottom-Gate-Elektrode wird, insbesondere auf einem Trägersubstrat, zuerst die Gate-Elektrodenschicht gebildet, anschließend die Isolatorschicht, die Halbleiterschicht und die Source/Drain-Elektrodenschichten. Bei einer Ausführung als Top-Gate-Elektrode werden, insbesondere auf einem Trägersubstrat, zuerst die Source/Drain-Elektrodenschichten gebildet, anschließend die Halbleiterschicht, die Isolatorschicht und die Gate-Elektrodenschicht.

Ein geeignetes Trägersubstrat auf dem die Source-Elektrodenschicht, die mindestens eine Drain-Elektrodenschicht, die - vorzugsweise vollflächig gedruckte - Halbleiterschicht, die - vorzugsweise ebenfalls vollflächig gedruckte -Isolatorschicht und die Gate-Elektrodenschicht vorzugsweise angeordnet werden, wird vorzugsweise aus einer flexiblen Kunststofffolie, insbesondere aus Polyester, Polyethylen, Polyethylenterephthalat oder Polyimid gebildet. Besonders bevorzugt ist es dabei, wenn als Trägersubstrat ein langgestrecktes flexibles Substrat aus Kunststofffolie, welche gegebenenfalls mehrschichtig ausgebildet ist, eingesetzt wird. Es sich weiterhin bewährt, wenn eine Dicke des Trägersubstrats im Bereich von 6 µm bis 200 µm, vorzugsweise im Bereich von 12 µm bis 50 µm, gewählt wird

Bei einem flexiblen Trägersubstrat ist es insbesondere von Vorteil, dass es in einem kontinuierlichen Prozesses verarbeitet werden kann, insbesondere ein Transport von Rolle zu Rolle vorgenommen werden kann. Dabei wird das unbeschichtete flexible Trägersubstrat auf eine Rolle aufgewickelt, das Trägersubstrat von der Rolle abgezogen und durch eine oder mehrere Prozessmaschinen zur Bildung von elektrischen Funktionsschichten einer Vielzahl von Feldeffekttransistoren und gegebenenfalls weiteren elektrischen Bauelementen bzw. von damit ausgestatteten elektrischen Schaltungen geführt, und schließlich als beschichtetes Trägersubstrat auf eine weitere Rolle aufgewickelt. Dies ermöglicht die Verarbeitung langer Trägersubstratbänder, wobei die Positionierung gegenüber der/den Prozessmaschinen nur einmal zu Beginn einer neuen Trägersubstratrolle erfolgen muss.

Besonders bewährt hat es sich, wenn der Feldeffekttransistor mindestens eine organische Funktionsschicht umfasst. Als Funktionsschicht werden alle zum Aufbau des Feldeffekttransistors benötigten Schichten bezeichnet.

Als "organische" Materialien zur Bildung einer organischen Funktionsschicht werden hier alle Arten von organischen, metallorganischen und anorganischen Kunststoffen angesehen, die im Englischen mit "plastics" bezeichnet werden. Eine Beschränkung im dogmatischen Sinn auf organisches Material als Kohlenstoff enthaltendes Material ist demnach nicht vorgesehen, sondern es ist vielmehr auch an den Einsatz von beispielsweise Silikonen gedacht. Weiterhin soll der Begriff keinerlei Beschränkung im Hinblick auf die Molekülgröße, insbesondere auf polymere und/oder oligomere Materialien unterliegen, sondern es ist durchaus auch der Einsatz von "small molecules" möglich.

Dabei können anorganische, insbesondere durch Sputtern oder Aufdampfen gebildete Funktionsschichten mit organischen Funktionsschichten kombiniert werden oder der Feldeffekttransistor vollständig mit organischen Funktionsschichten aufgebaut werden. Es hat sich bewährt, wenn mindestens eine organische Funktionsschicht, insbesondere die Halbleiterschicht und/oder die Isolatorschicht, durch Drucken gebildet ist.

Dabei hat es sich bewährt, die Source/Drain-Elektrodenschichten sowie die Gate-Elektrodenschicht jeweils aus mindestens einer metallischen Schicht zu bilden, beispielsweise aus mindestens einem der Materialien Gold, Silber, Kupfer, Aluminium, Platin, Titan oder ähnlichem. Diese werden dann vorzugsweise mittels Laser oder Ätzen strukturiert. Als elektrisch leitfähige organische Materialien zur Bildung von Elektrodenschichten haben sich unter anderem Polyanilin oder Polypyrrol bewährt. Auch ein Schichtstapel aus mindestens zwei Schichten kann zur Bildung einer Elektrodenschicht eingesetzt werden.

Eine Ausbildung der Halbleiterschicht und/oder der Isolatorschicht als organische Funktionsschicht hat sich bewährt. Als organisches Isolationsmaterial hat sich unter anderem Polyvinylphenol oder Polyhydroxystyrol (PHS/PVP) bewährt. Als organisches Halbleitermaterial eignet sich beispielsweise Polythiophen.

Bei der Positionierung eines Lasers im Hinblick auf eine bereits auf einem Trägersubstrat gebildete Funktionsschicht ergeben sich üblicherweise geringe Abweichungen zur idealen Position, so dass eine Abweichung der gebildeten strukturierten Funktionsschicht zum Layout resultiert. Wird ein Photolack vollflächig auf eine Funktionsschicht aufgetragen, dieser über eine Maske belichtet, die nicht gehärteten Bereiche des Lacks entfernt, ein Ätzprozess durchgeführt und anschließend der Photolack entfernt, so ergeben sich durch geringe Abweichungen bei der Positionierung der Maske von ihrer idealen Position auch hier für die gebildete Funktionsschicht gegenüber dem Layout Lageabweichungen.

Weiterhin kann eine Funktionsschicht beispielsweise mit einer ätzresistenten Maskenschicht bereits in den gewünschten Bereichen bedruckt und die nicht bedruckten Bereiche der Funktionsschicht durch Ätzen entfernt werden. Anschließend wird die ätzresistente Maskenschicht abgelöst und die darunter verbliebenen, in der gewünschten Form strukturierten Bereiche der Funktionsschicht freigelegt. Beim Drucken der Maskenschicht ergeben sich wie beim direkten Druck einer Funktionsschicht ebenso Abweichungen von der idealen Position. Diese übertragen sich von der Maskenschicht direkt auf die damit strukturierte Funktionsschicht.

Weiterhin hat sich bewährt, wenn ein Tintenstrahl-Strukturierungsverfahren verwendet wird, wobei hohle Prozessgeschwindigkeiten möglich sind. Dabei kann eine Funktionsschicht mittels Tintenstrahldruck unmittelbar und bereits in der gewünschten Form auf dem Trägersubstrat gebildet werden. Das Tintenstrahlverfahren ermöglicht aber auch den Auftrag einer Maskenschicht, um eine zuvor gebildete Funktionsschicht damit zu strukturieren.

Vorzugsweise wird eine Relativ-Geschwindigkeit des Trägersubstrats gegenüber einer Strukturierungseinheit in einem kontinuierlichen Verarbeitungsprozess im Bereich von 0,5 bis 200 m/min, vorzugsweise im Bereich von 10 bis 100 m/min, gewählt. Dies ermöglicht eine Massenfertigung von elektronischen Bauelementen und Schaltungen bei geringen Herstellungskosten.

Es hat sich bewährt, wenn eine Funktionsschicht des Feldeffekttransistors mit jeweils einer Schichtdicke im Bereich von 1 nm bis 100 µm, vorzugsweise im Bereich von 10 nm bis 300 nm, ausgebildet wird.

Ein Logikbauelement, welches mindestens einen erfindungsgemäßen Feldeffekttransistor aufweist, hat sich bewährt. Ein solches Logikbauelement ist insbesondere ein Bauteil aus der Gruppe umfassend Inverterbauelemente, NOR-Gatter, NAND-Gatter, AND-Gatter und OR-Gatter.

Besonders bevorzugt ist es dabei, wenn das Logikbauelement ein Inverterbauelement ist, das einen Feldeffekttransistor und mindestens ein Ladebauelement umfasst, welches mindestens eine erste Elektrode und mindestens eine zweite Elektrode aufweist, wobei die mindestens eine zweite Elektrode zur Verbindung mit einer Versorgungsspannung ausgebildet ist, und wobei mindestens eine der ersten Elektroden mit mindestens einer Drain-Elektrodenschicht des Feldeffekttransistors elektrisch leitend verbunden ist, welche senkrecht zur Ebene der mindestens einen Source-Elektrodenschicht und der mindestens einen Drain-Elektrodenschicht gesehen zumindest bereichsweise mit der Gate-Elektrodenschicht überlappt. Es wird also eine Drain-Elektrodenschicht angeschlossen, welche an ein Kanalgebiet mit Gate-Elektrodenschicht angrenzt.

Es hat sich bewährt, wenn die elektrisch leitende Verbindung zwischen der mindestens einen ersten Elektrode mit der mindestens einen Drain-Elektrodenschicht des Feldeffekttransistors durch mindestens eine Leiterbahn und/oder mindestens ein Via ausgebildet ist. Als Leiterbahn wird dabei eine elektrische Verbindung in einer Ebene verstanden, während als Via eine elektrisch leitende Verbindung über mehrere Ebenen hinweg verstanden wird. Vorzugsweise umfasst das Inverterbauelement einen Feldeffekttransistor mit mindestens einer Source-Elektrodenschicht und mindestens zwei DrainElektrodenschichten sowie das mindestens eine Ladebauelement mit mindestens zwei ersten Elektroden, wobei jeweils eine der Drain-Elektrodenschichten mit jeweils einer der ersten Elektroden elektrisch leitend verbunden ist.

Eine elektrische Schaltung umfassend mindestens ein erfindungsgemäßes Logikbauelement hat sich bewährt. Besonders bevorzugt ist dabei eine elektrische Schaltung, die mindestens zwei Logikbauelement, insbesondere mindestens zwei Inverterbauelemente umfasst.

Dabei hat es sich als vorteilhaft erwiesen, wenn ein erstes Inverterbauelement eine erste Gate-Elektrodenschicht aufweist und die erste Gate-Elektrodenschicht mit der mindestens einen Leiterbahn und/oder dem mindestens einen Via eines zweiten Inverterbauelements elektrisch leitend verbunden ist, welche(s) einem zweiten Inverterbauelement zugeordnet ist und die mindestens eine Drain-Elektrodenschicht und die mindestens eine erste Elektrode des Ladebauelements des zweiten Inverterbauelements elektrisch leitend miteinander verbindet.

Es hat sich dabei bewährt, wenn die mindestens eine Leiterbahn auf der Ebene der mindestens einen Souce-Elektrodenschicht und der mindestens einen Drain-Elektrodenschicht angeordnet ist und dass die erste Gate-Elektrodenschicht und die mindestens eine Leiterbahn über mindestens ein Via in der Halbleiterschicht und der Isolatorschicht elektrisch leitend miteinander verbunden sind.

Es hat sich dabei aber auch bewährt, wenn die erste Gate-Elektrodenschicht über mindestens ein Via in der Halbleiterschicht und der Isolatorschicht elektrisch leitend mit der mindestens einen Drain-Elektrodenschicht und der mindestens einen ersten Elektrode des zweiten Inverterbauelements verbunden ist. Besonders bevorzugt ist dabei ein Verfahren, bei welchen über mindestens ein Via in der Halbleiterschicht und der Isolatorschicht mit Bildung der Gate-Elektrodenschicht gleichzeitig auch die elektrisch leitende Verbindung mit der mindestens einen Drain-Elektrodenschicht und der mindestens einen ersten Elektrode des zweiten Inverterbauelements gebildet wird.

Dabei ist es bevorzugt, wenn die mindestens zwei zweiten Bauelemente in Druckrichtung der Leiterbahn gesehen nacheinander und benachbart zueinander angeordnet sind. Der Abstand zwischen den zweiten Bauelementen ist dabei auf die tatsächlich auftretenden Registertoleranzen beim Drucken abzustimmen.

Weiterhin hat es sich bewährt, wenn mindestens zwei erste Bauelemente ausgebildet sind und durch die Leiterbahn eines der ersten Bauelemente mit einem der zweiten Bauelemente elektrisch leitend verbunden ist, so dass mindestens ein erstes Bauelement und mindestens ein zweites Bauelement ungenutzt und überzählig vorhanden sind.

Auch für die mindestens zwei ersten Bauelemente ist es von Vorteil, wenn diese in Druckrichtung der Leiterbahn gesehen nacheinander und benachbart zueinander angeordnet sind.

Es hat sich bewährt, wenn das zweite Bauelement als Ladebauelement ausgebildet ist, welches mindestens eine erste Elektrode als elektrisch leitende Funktionsschicht und mindestens eine zweite Elektrode aufweist, wobei die mindestens eine zweite Elektrode zur Verbindung mit einer Versorgungsspannung ausgebildet ist.

Es zeigt:
- Figur 1a: einen Querschnitt A - A' durch einen Feldeffekttransistor, welcher auf einem Trägersubstrat angeordnet ist;
- Figur 1b: eine vereinfachte Draufsicht auf den Feldeffekttransistor und das Trägersubstrat aus Figur 1a;
- Figur 2a: einen Querschnitt B - B' durch einen weiteren Feldeffekttransistor, welcher auf einem Trägersubstrat angeordnet ist;
- Figur 2b: die vereinfachte Draufsicht auf den Feldeffekttransistor und das Trägersubstrat aus Figur 2a;
- Figur 3: ein Logikbauelement in Form eines Inverterbauelements in vereinfachter Draufsicht;
- Figur 4: eine elektrische Schaltung mit zwei Logikbauelementen, wobei jedes Logikbauelement ein Ladebauelement umfasst;
- Figur 5: eine elektrische Schaltung mit zwei Logikbauelementen, wobei jedes Logikbauelement zwei Ladebauelemente umfasst; und
- Figur 6: eine weitere elektrische Schaltung mit zwei Logikbauelementen, wobei jedes Logikbauelement zwei Ladebauelemente umfasst, und
- Figur 7: ein bevorzugtes Layout für eine elektrische Schaltung mit einer Vielzahl von Logikbauelementen gemäß Figur 6.

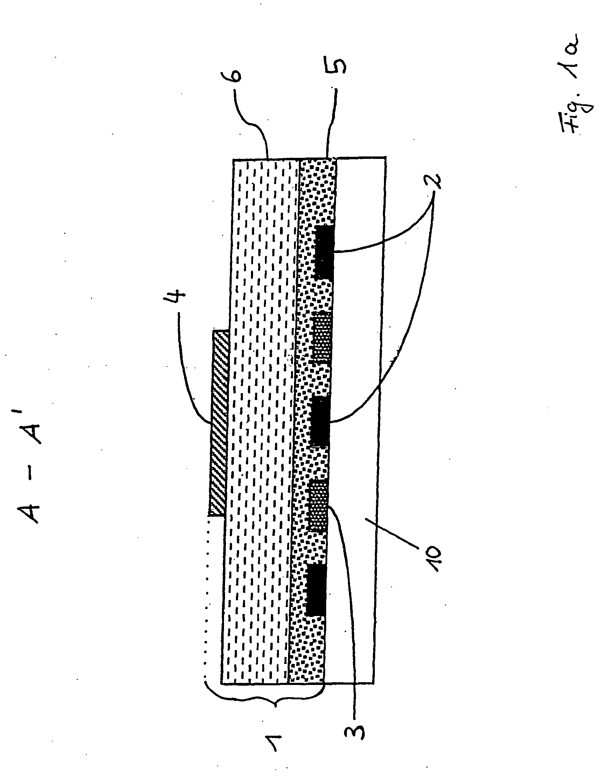

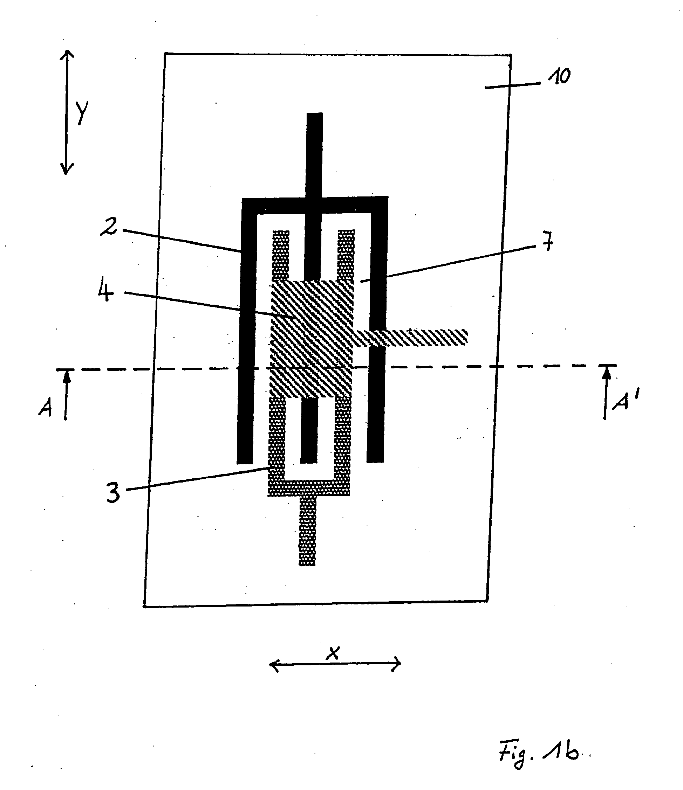

Figur 1a zeigt einen Querschnitt A - A' durch einen Feldeffekttransistor 1, welcher auf einem Trägersubstrat 10 aus PET angeordnet ist. Der Feldeffekttransistor 1 umfasst als Funktionsschichten eine kammförmig strukturierte Source-Elektrodenschicht.2 aus Gold, Silber, PEDOT oder PANI und in der gleichen Ebene eine kammförmig strukturierte Drain-Elektrodenschicht 3 aus dem gleichen Material. Darauf sind vollflächig eine Halbleiterschicht 5 aus Polythiophen und eine Isolatorschicht 6 aus Polyhydroxystyrol (PHS/PVP) aufgedruckt. Auf der Isolatorschicht 6 befindet sich eine Gate-Elektrodenschicht 4, welche den Kanal 7 (siehe Figur 1b) zwischen der Source-Elektrodenschicht 2 und der Drain-Elektrodenschicht 3 nur teilweise bedeckt.

Figur 1b zeigt eine vereinfachte Draufsicht auf den Feldeffekttransistor 1 und das Trägersubstrat 10 aus Figur 1a, wobei die Darstellung der Halbleiterschicht 5 sowie der Isolatorschicht 6 vernachlässigt wurde. Aus der Figur 1b wird somit die Lage der kammförmigen Source-Elektrodenschicht 2 mit drei Kammzähnen gegenüber der kammförmigen Drain-Elektrodenschicht 3 mit zwei Kammzähnen ersichtlich, welche miteinander verzahnt auf dem Trägersubstrat 10 angeordnet sind. Zwischen der Source-Elektrodenschicht 2 und der Drain-Elektrodenschicht 3 befindet sich der Kanal 7, welcher senkrecht zur Ebene des Trägersubstrats 10 gesehen einen mäanderförmigen Verlauf zeigt. Die auf der Source-Elektrodenschicht 2 und der Drain-Elektrodenschicht 3 angeordnete Halbleiterschicht 5 und die Isolatorschicht 6 sind hier nicht gezeichnet, um die Lage und Flächenausdehnung der Gate-Elektrodenschicht 4 im Hinblick auf den Kanal 7 aufzeigen zu können. Es zeigt sich, dass die Gate-Elektrodenschicht 4 den Kanal 7 nur teilweise bedeckt. Eine Lageverschiebung der Gate-Elektrodenschicht 4 hinsichtlich ihrer Ausrichtung auf die Source-Elektrodenschicht 2 und die Drain-Elektrodenschicht 3 in den gekennzeichneten x-Richtungen oder y-Richtungen aufgrund von Registertoleranzen bei der Bildung der Gate-Elektrodenschicht 4 wirkt sich auf wesentliche elektrische Eigenschaften des Feldeffekttransistors 1 (ON-Strom, Kapazität) nicht aus, da die Flächenausdehnung der Gate-Elektrodenschicht 4 so gewählt ist, dass auch bei einer herstellungsbedingt maximal möglichen Verschiebung der Gate-Elektrodenschicht 4 in x- und/oder y-Richtung eine Position von Teilen der Gate-Elektodenschicht 4 außerhalb des von den Source- und Drain-Elektodenschichten 2, 3 begrenzten Kanalgebiets nicht möglich ist.

Die einfachste Ausführungsform des erfindungsgemäßen Feldeffekttransistors wäre hier eine solche, die eine kammförmige Source-Elektrodenschicht zeigt, die zumindest mit zwei, miteinander verbundenen Kammzinken ausgebildet ist und eine lediglich streifenförmige Drain-Elektrodenschicht aufweist, welche sich zwischen den beiden Kammzinken der Source-Elektrodenschicht befindet.

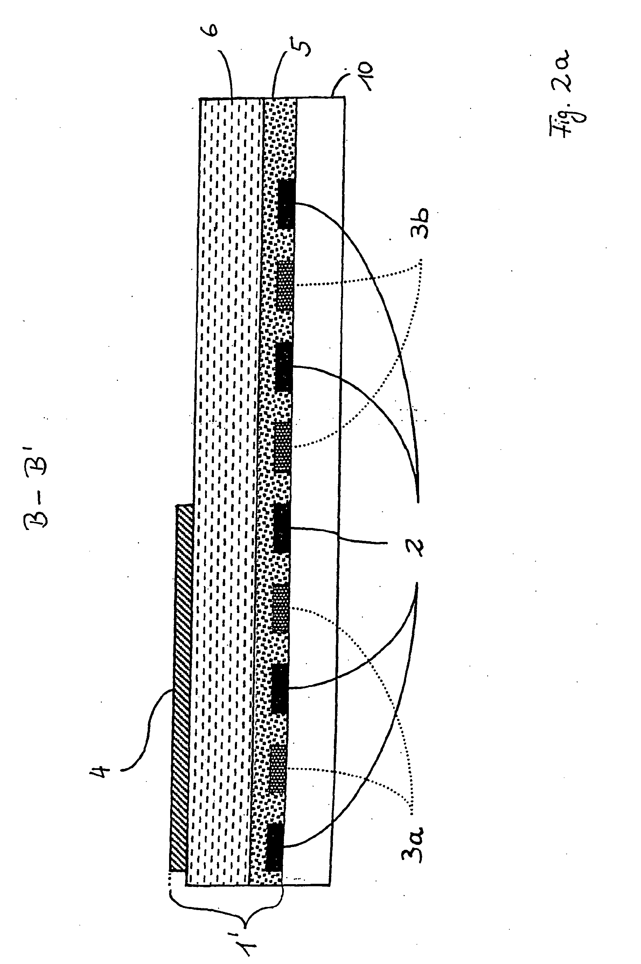

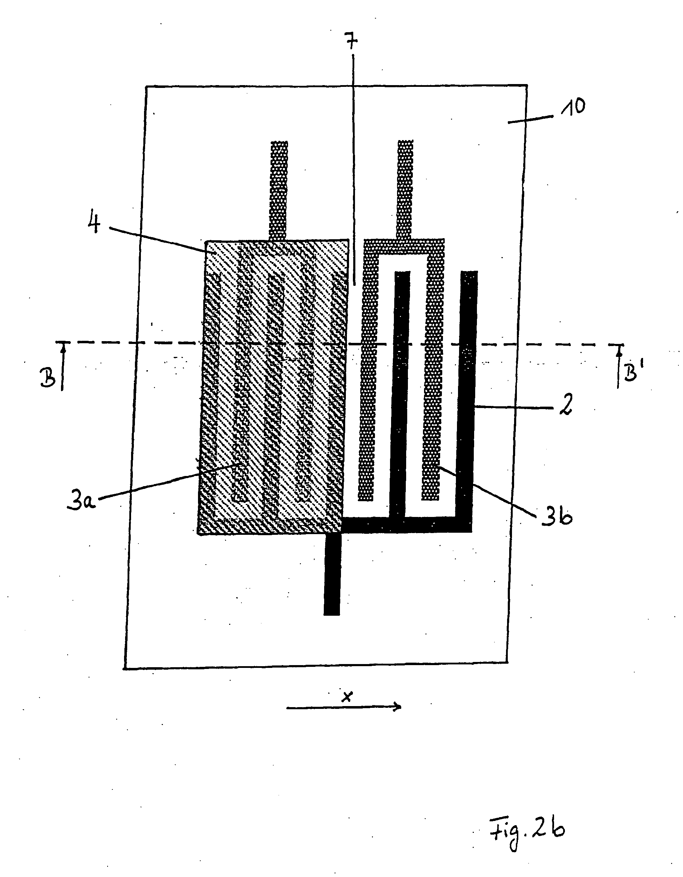

Figur 2a zeigt einen Querschnitt B - B' durch einen weiteren Feldeffekttransistor 1', welcher auf einem Trägersubstrat 10 angeordnet ist. Der Feldeffekttransistor 1' umfasst als Funktionsschichten eine kammförmig strukturierte Source-Elektrodenschicht 2 aus Gold, Silber, PEDOT oder PANI und in der gleichen Ebene zwei voneinander elektrisch isolierte, kammförmig strukturierte Drain-Elektrodenschichten 3a, 3b aus dem gleichen Material. Darauf sind vollflächig eine Halbleiterschicht 5 aus einem druckbaren polymeren Material, wie Polythiophen, und eine Isolatorschicht 6 aus Polyhydroxystyrol (PSH/PVP) aufgedruckt. Auf der Isolatorschicht 6 befindet sich eine Gate-Elektrodenschicht 4, welche den Kanal 7 (siehe Figur 2b) zwischen der Source-Elektrodenschicht 2 und den Drain-Elektrodenschichten 3a, 3b nur teilweise bedeckt. Die Drain-Elektrodenschichten könnten hier alternativ auch derart ausgebildet sein, dass diese lediglich in Form von vier nebeneinander liegenden Linien ausgebildet sind, welche jeweils in die kammförmige Source-Elektrodenschicht 2 hineinragen und miteinander nicht elektrisch leitend verbunden sind. Auch eine lediglich linienförmige Ausbildung der Source-Elektrodenschicht wäre möglich, so dass mehrere, hier insbesondere fünf Source-Elektrodenschichten ohne elektrischen Kontakt nebeneinander auf dem Trägersubstrat 10 vorliegen könnten.

Figur 2b zeigt die vereinfachte Draufsicht auf den Feldeffekttransistor 1' und das Trägersubstrat 10 aus Figur 2a, wobei die Darstellung der Halbleiterschicht 5 sowie der Isolatorschicht 6 vernachlässigt wurde. Aus der Figur 2b wird somit die Lage der kammförmigen Source-Elektrodenschicht 2 mit fünf Kammzähnen gegenüber den beiden kammförmigen Drain-Elektrodenschichten 3a, 3b mit je zwei Kammzähnen ersichtlich, welche miteinander verzahnt auf dem Trägersubstrat 10 angeordnet sind. Zwischen der Source-Elektrodenschicht 2 und den Drain-Elektrodenschichten 3a, 3b befindet sich der Kanal 7, welcher senkrecht zur Ebene des Trägersubstrats 10 gesehen einen mäanderförmigen Verlauf zeigt. Die auf der Source-Elektrodenschicht 2 und den Drain-Elektrodenschichten 3a, 3b angeordnete Halbleiterschicht 5 und die Isolatorschicht 6 sind hier nicht gezeichnet, um die Lage und Flächenausdehnung der Gate-Elektrodenschicht 4 im Hinblick auf den Kanal 7 aufzeigen zu können. Es zeigt sich, dass die Gate-Elektrodenschicht 4 den Kanal 7 nur teilweise bedeckt. Eine Lageverschiebung der Gate-Elektrodenschicht 4 hinsichtlich ihrer Ausrichtung auf die Source-Elektrodenschicht 2 und die Drain-Elektrodenschichten 3a, 3b in der gekennzeichneten x-Richtung aufgrund von Registertoleranzen bei der Bildung der Gate-Elektrodenschicht 4 wirkt sich auf die elektrischen Eigenschaften des Feldeffekttransistors 1' nicht aus, da die Flächenausdehnung der Gate-Elektrodenschicht 4 so gewählt ist, dass auch bei einer herstellungsbedingt maximal möglichen Verschiebung der Gate-Elektrodenschicht 4 in die gekennzeichnete x-Richtung eine Position von Teilen der Gate-Elektodenschicht 4 außerhalb des von den Source- und Drain-Elektodenschichten 2, 3a, 3b begrenzten Kanalgebiets nicht möglich ist.
Der Feldeffekttransistor gemäß den Figuren 2a und 2b kann alternativ auch mit drei oder mehr Drain-Elektrodenschichten ausgebildet werden, wobei die Gate-Elektrodenschicht mindestens eine Drain-Elektrodenschicht, oder auch mehrere Drain-Elektrodenschichten gleichzeitig, überdeckt. Mindestens eine Drain-Elektrodenschicht und/oder ein Kanalbereich liegt jedoch als überzählige bzw. ungenutzte Struktur vor.

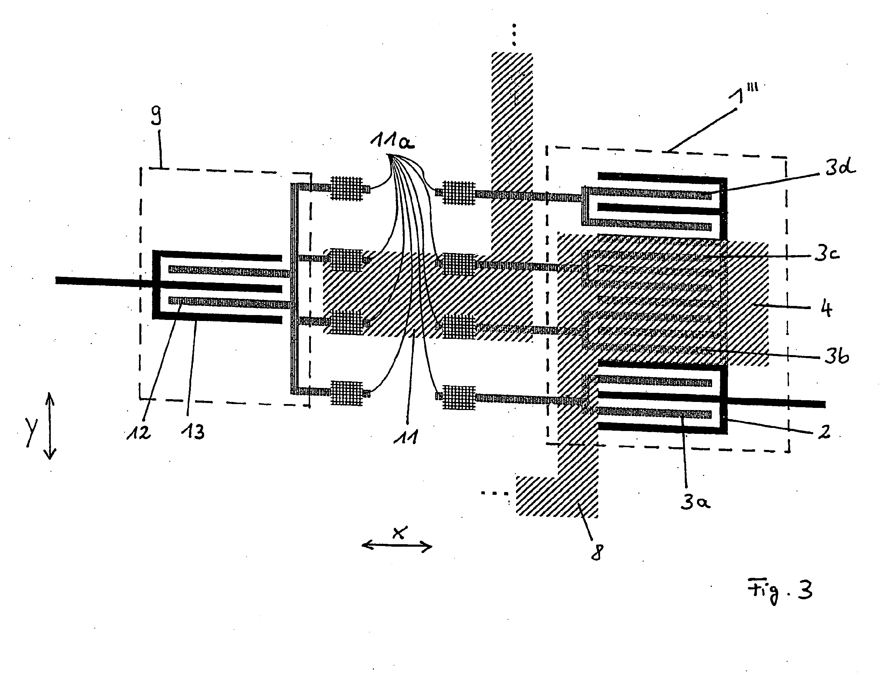

Figur 3 zeigt in der vereinfachten Draufsicht ein Logikbauelement in Form eines Inverterbauelements mit einem Feldeffekttransistor 1"' sowie einem Ladebauelement 9. Der Invertereingang des Inverterbauelements ist mit dem Bezugszeichen 8 gekennzeichnet. Zur besseren Visualisierung der Lage der diversen Elektrodenschichten zueinander wurde auf die Darstellung der Halbleiterschichten und der Isolatorschichten in Figur 3 verzichtet. Der Feldeffekttransistor 1"' weist eine Source-Elektrodenschicht 2 sowie vier voneinander elektrisch isolierte Drain-Elektrodenschichten 3a, 3b, 3c, 3d auf. Die Source-Elektrodenschicht 2 ist an eine erste Versorgungsspannung U₁ anschließbar. Die Gate-Elektrodenschicht 4 des Feldeffekttransistors 1"' bedeckt lediglich die beiden mittleren Drain-Elektrodenschichten 3a, 3b, während die beiden äußeren Drain-Elektrodenschichten 3a, 3d nicht bedeckt und somit ungenutzt sind. Eine Lageungenauigkeit der Gate-Elektrodenschicht 4 aufgrund von Registertoleranzen ist in den y-Richtungen durch die überzähligen Drain-Elektrodenschichten 3a, 3d kompensierbar. Eine Lageungenauigkeit der Gate-Elektrodenschicht 4 aufgrund von Registertoleranzen in den x-Richtungen wird durch die vergrößerte Breite der Gate-Elektrodenschicht 4 gegenüber der Breite der Source-und Drain-Elektrodenschichten 2, 3a, 3b, 3c, 3d kompensiert. Das Ladebauelement 9 weist eine erste Elektrode 12 und eine zweite Elektrode 13 auf, wobei die zweite Elektrode 13 mit einer Versorgungsspannung verbindbar ist.

Die Drain-Elektrodenschichten 3b, 3c sind mittels einer Leiterbahn 11 elektrisch leitend mit der ersten Elektrode 12 des Ladebauelements 9 verbunden. In der nicht gesondert dargestellten Halbleiterschicht und der Isolatorschicht sind Öffnungen, sogenannte Vias 11a vorgesehen, um eine elektrisch leitende Verbindung zwischen der Source/Drain-Ebene und der Gate-Ebene herstellen zu können. Die Leiterbahn 11, welche die Drain-Elektrodenschichten 3b, 3c elektrisch leitend über mindestens eine der darüber oder darunter angeordneten Vias 11a mit der zweiten Elektrode 13 des Ladebauelements 9 verbindet, bildet die Gate-Elektrodenschicht 4 des Feldeffekttransistors 1"', bzw. den Invertereingang 8 des Inverterbauelements, oder ist mit dieser direkt oder indirekt über Vias elektrisch leitend verbunden.

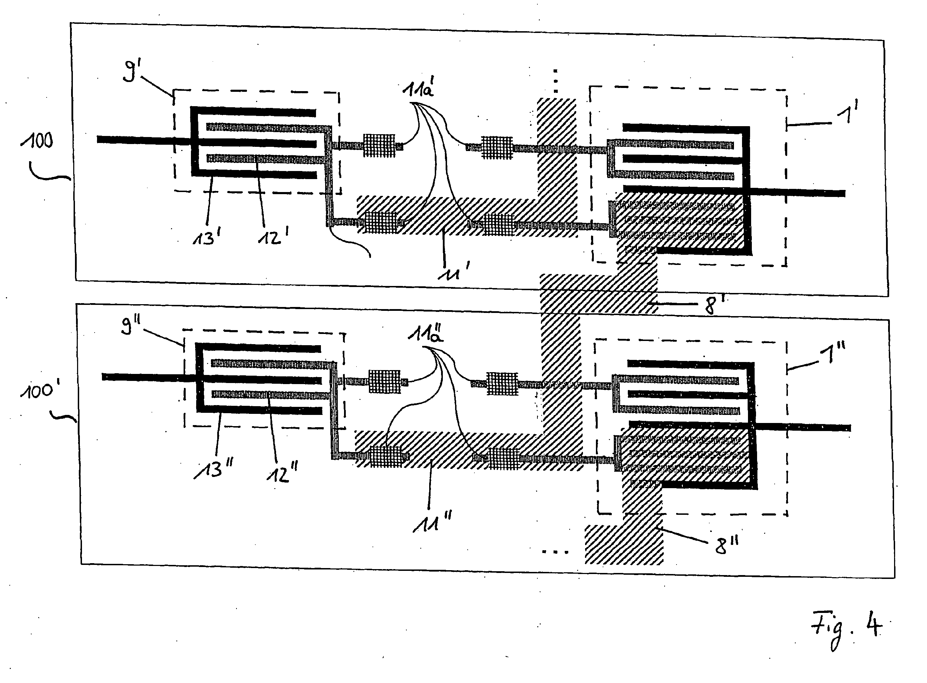

Figur 4 zeigt in der vereinfachten Draufsicht eine elektrische Schaltung, mit einem ersten Logikbauelement in Form eines ersten Inverterbauelements 100, zur Identifizierung der zugehörigen Bauteile von einer Linie umgrenzt, und ein zweites Logikbauelement, welches in Form eines zweiten Inverterbauelements 100' ausgebildet und zur Identifizierung der zugehörigen Bauteile ebenfalls von einer Linie umgrenzt ist. Zur besseren Visualisierung der Lage der diversen Elektrodenschichten zueinander wurde auf die Darstellung der Halbleiterschichten und der Isolatorschichten in Figur 4 verzichtet.

Das erste Inverterbauelement 100 weist einen Feldeffekttransistor 1' gemäß den Figuren 2a, 2b sowie ein erstes Ladebauelement 9' auf. Die Source-Elektrodenschicht 2 (siehe Figur 2b) des ersten Feldeffekttransistors 1' wird an eine erste Versorgungsspannung U₁ angeschlossen. Das erste Ladebauelement 9' weist eine erste Elektrode 12' und eine zweite Elektrode 13' auf, wobei die zweite Elektrode 13' mit einer zweiten Versorgungsspannung U₂ verbunden wird. Der Invertereingang des ersten Inverterbauelements 100 ist mit dem Bezugszeichen 8' gekennzeichnet. Die erste Drain-Elektrodenschicht 3a (siehe Figur 2b) des ersten Feldeffekttransistors 1' ist mittels einer Leiterbahn 11' elektrisch leitend mit der ersten Elektrode 12' des ersten Ladebauelements 9' verbunden.

Das zweite Inverterbauelement 100' weist einen Feldeffekttransistor 1" auf, welcher baugleich mit dem ersten Inverterbauelement 1' ausgebildet ist, sowie ein zweites Ladebauelement 9", welches baugleich zum ersten Ladebauelement 9' ausgebildet ist und eine erste Elektrode 12" und eine mit einer zweiten Versorgungsspannung U₂ verbundene zweite Elektrode 13" aufweist. Der Invertereingang des zweiten Inverterbauelements 100' ist mit dem Bezugszeichen 8" gekennzeichnet. Die erste Drain-Elektrodenschicht 3a (siehe Figur 2b) des zweiten Feldeffekttransistors 1" ist mittels einer Leiterbahn 11" elektrisch leitend mit der ersten Elektrode 12" des zweiten Ladebauelements 9" verbunden.

In der nicht gesondert dargestellten Halbleiterschicht und der Isolatorschicht sind Öffnungen, sogenannte Vias 11a', 11a" vorgesehen, um eine elektrisch leitende Verbindung zwischen der Source/Drain-Ebene und der Gate-Ebene herstellen zu können.

Die Leiterbahn 11" des zweiten Inverterbauelements 100', welche die erste Drain-Elektrodenschicht 3a (siehe Figur 2b) des zweiten Feldeffekttransistors 1" über mindestens eine der darüber oder darunter angeordneten beiden Vias 11a" elektrisch leitend mit der ersten Elektrode 12" des zweiten Ladebauelements 9" verbindet, bildet die Gate-Elektrodenschicht 4 des ersten Feldeffekttransistors 1', bzw. den Invertereingang 8' des ersten Inverterbauelements 100, oder ist mir dieser direkt oder indirekt über Vias elektrisch leitend verbunden.

Die Leiterbahn 11' des ersten Inverterbauelements 100, welche die erste Drain-Elektrodenschicht 3a (siehe Figur 2b) des ersten Feldeffekttransistors 1' elektrisch leitend mit der ersten Elektrode 12' des ersten Ladebauelements 9' verbindet, ist über mindestens eines der darüber oder darunter angeordneten beiden Vias 11a' mit einem weiteren elektrischen Bauelement elektrisch leitend verbunden.

Die Leiterbahnen 11', 11" des ersten und zweiten Inverterbauelements 100, 100' sind hier gleichzeitig mit der Bildung der Gate-Elektrodenschichten 4 ausgebildet.

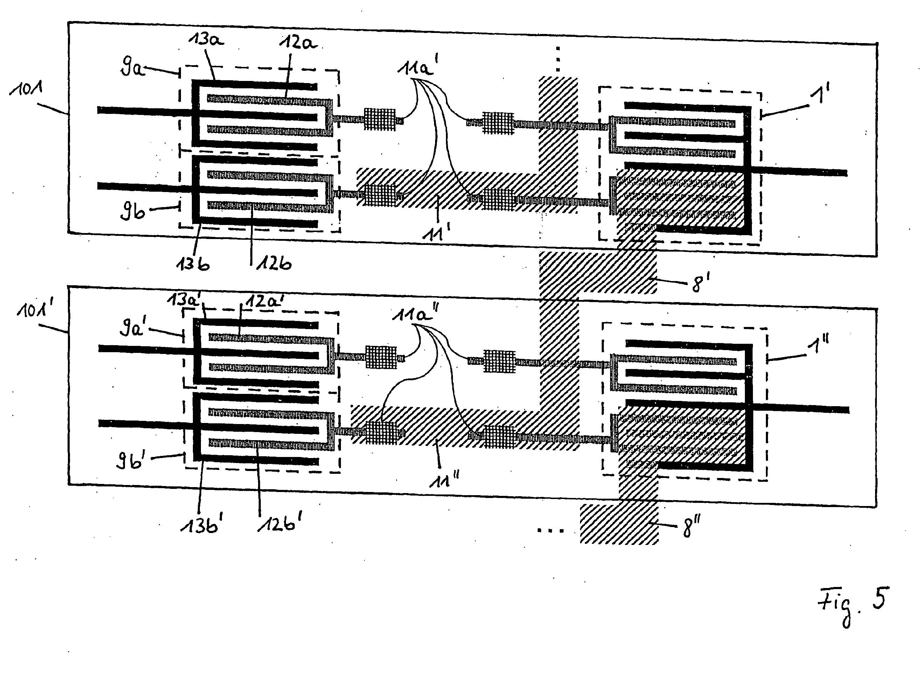

Figur 5 zeigt in der vereinfachten Draufsicht eine ähnliche elektrische Schaltung wie Figur 4. Die elektrische Schaltung weist ein erstes Logikbauelement in Form eines ersten Inverterbauelements 101, zur Identifizierung der zugehörigen Bauteile von einer Linie umgrenzt, und ein zweites Logikbauelement in Form eines zweiten Inverterbauelements 101' auf, welches zur Identifizierung der zugehörigen Bauteile ebenfalls von einer Linie umgrenzt ist. Zur besseren Visualisierung der Lage der diversen Elektrodenschichten zueinander wurde auch hier auf die Darstellung der Halbleiterschichten und der Isolatorschichten, wie bereits in Figur 4, verzichtet.

Das erste Inverterbauelement 101 weist einen Feldeffekttransistor 1' gemäß den Figuren 2a, 2b sowie ein erstes Ladebauelement 9a und ein zweites Ladebauelement 9b auf. Die Source-Elektrodenschicht 2 (siehe Figur 2b) des ersten Feldeffekttransistors 1' wird an eine erste Versorgungsspannung U₁ angeschlossen. Das erste Ladebauelement 9a weist eine erste Elektrode 12a und eine zweite Elektrode 13a auf, wobei die zweite Elektrode 13a mit einer zweiten Versorgungsspannung U₂ verbunden wird. Das zweite Ladebauelement 9b weist eine erste Elektrode 12b und eine zweite Elektrode 13b auf, wobei die zweite Elektrode 13b ebenfalls mit der zweiten Versorgungsspannung U₂ verbunden wird. Der Invertereingang des ersten Inverterbauelements 101 ist mit dem Bezugszeichen 8' gekennzeichnet. Die erste Drain-Elektrodenschicht 3a (siehe Figur 2b) des ersten Feldeffekttransistors 1' ist mittels einer Leiterbahn 11' elektrisch leitend mit der ersten Elektrode 12b des zweiten Ladebauelements 9b verbunden.

Das zweite Inverterbauelement 101' weist einen Feldeffekttransistor 1" auf, welcher baugleich mit dem ersten Inverterbauelement 1' ausgebildet ist, sowie ein drittes Ladebauelement 9a', welches baugleich zum ersten Ladebauelement 9a ausgebildet ist und ein viertes Ladebauelement 9b', welches baugleich mit dem zweiten Ladebauelement 9b ausgebildet ist. Das dritte Ladebauelement 9a' weist eine erste Elektrode 12a' und eine mit einer zweiten Versorgungsspannung U₂ verbundene zweite Elektrode 13a' auf. Das vierte Ladebauelement 9b' weist eine erste Elektrode 12b' und eine mit der zweiten Versorgungsspannung U₂ verbundene zweite Elektrode 13b' auf. Der Invertereingang des zweiten Inverterbauelements 101' ist mit dem Bezugszeichen 8" gekennzeichnet. Die erste Drain-Elektrodenschicht 3a (siehe Figur 2b) des zweiten Feldeffekttransistors 1" ist mittels einer Leiterbahn 11" elektrisch leitend mit der ersten Elektrode 12b' des vierten Ladebauelements 9b' verbunden.

In der nicht gesondert dargestellten Halbleiterschicht und der Isolatorschicht sind Öffnungen, sogenannte Vias 11a', 11a" vorgesehen, um eine elektrisch leitende Verbindung zwischen der Source/Drain-Ebene und der Gate-Ebene herstellen zu können.

Die Leiterbahn 11" des zweiten Inverterbauelements 101', welche die erste Drain-Elektrodenschicht 3a (siehe Figur 2b) des zweiten Feldeffekttransistors 1" über mindestens eine der darüber oder darunter angeordneten beiden Vias 11a" elektrisch leitend mit der ersten Elektrode 12b' des vierten Ladebauelements 9b' verbindet, bildet die Gate-Elektrodenschicht 4 des ersten Feldeffekttransistors 1', bzw. den Invertereingang 8' des ersten Inverterbauelements 101, oder ist mit dieser direkt oder indirekt über Vias elektrisch leitend verbunden.

Die Leiterbahn 11' des ersten Inverterbauelements 101, welche die erste Drain-Elektrodenschicht 3a (siehe Figur 2b) des ersten Feldeffekttransistors 1' elektrisch leitend mit der ersten Elektrode 12b des zweiten Ladebauelements 9b verbindet, ist über mindestens eines der darüber oder darunter angeordneten beiden Vias 11a' mit einem weiteren elektrischen Bauelement elektrisch leitend verbunden.

Die Leiterbahnen 11', 11" des ersten und zweiten Inverterbauelements 101, 101' sind hier gleichzeitig mit der Bildung der Gate-Elektrodenschichten 4 ausgebildet. Da zwischen dem ersten Ladebauelement 9a und dem Feldeffekttransistor 1' sowie zwischen dem Ladebauelement 9a' und dem Feldeffekttransistor 1" keine elektrisch leitende Verbindung ausgebildet ist, treten hier auch keine Leck-Ströme auf.

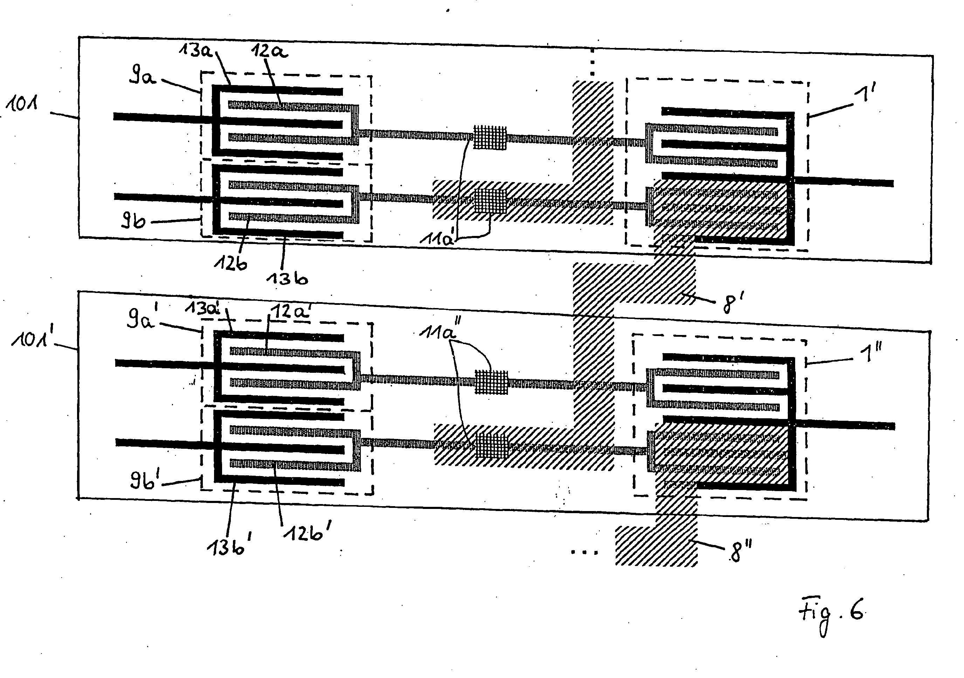

Figur 6 zeigt in der vereinfachten Draufsicht eine ähnliche elektrische Schaltung wie Figur 5. Die elektrische Schaltung weist ein erstes Logikbauelement in Form eines ersten Inverterbauelements 101, zur Identifizierung der zugehörigen Bauteile von einer Linie umgrenzt, und ein zweites Logikbauelement in Form eines zweiten Inverterbauelements 101' auf, welches zur Identifizierung der zugehörigen Bauteile ebenfalls von einer Linie umgrenzt ist. Zur besseren Visualisierung der Lage der diversen Elektrodenschichten zueinander wurde auch hier auf die Darstellung der Halbleiterschichten und der Isolatorschichten, wie bereits in den Figuren 4 und 5, verzichtet.

Das erste Inverterbauelement 101 weist einen Feldeffekttransistor 1' gemäß den Figuren 2a, 2b sowie ein erstes Ladebauelement 9a und ein zweites Ladebauelement 9b auf. Die Source-Elektrodenschicht 2 (siehe Figur 2b) des ersten Feldeffekttransistors 1' wird an eine erste Versorgungsspannung U₁ angeschlossen. Das erste Ladebauelement 9a weist eine erste Elektrode 12a und eine zweite Elektrode 13a auf. Das zweite Ladebauelement 9b weist eine erste Elektrode 12b und eine zweite Elektrode 13b auf, wobei die zweite Elektrode 13b mit einer zweiten Versorgungsspannung U₂ verbunden wird. Der Invertereingang des ersten Inverterbauelements 101 ist mit dem Bezugszeichen 8' gekennzeichnet. Die erste Drain-Elektrodenschicht 3a (siehe Figur 2b) des ersten Feldeffekttransistors 1' ist mittels eines Via 11a' elektrisch leitend mit der ersten Elektrode 12b des zweiten Ladebauelements 9b verbunden.

Das zweite Inverterbauelement 101' weist einen Feldeffekttransistor 1" auf, welcher baugleich mit dem ersten Inverterbauelement 1' ausgebildet ist, und weist weiterhin ein drittes Ladebauelement 9a', welches baugleich zum ersten Ladebauelement 9a ausgebildet ist und ein viertes Ladebauelement 9b', welches baugleich mit dem zweiten Ladebauelement 9b ausgebildet ist, auf. Das dritte Ladebauelement 9a' weist eine erste Elektrode 12a' und eine zweite Elektrode 13a' auf. Das vierte Ladebauelement 9b' weist eine erste Elektrode 12b' und eine mit einer zweiten Versorgungsspannung U₂ verbundene zweite Elektrode 13b' auf. Der Invertereingang des zweiten Inverterbauelements 101' ist mit dem Bezugszeichen 8" gekennzeichnet. Die erste Drain-Elektrodenschicht 3a (siehe Figur 2b) des zweiten Feldeffekttransistors 1" ist mittels eines Via 11a" elektrisch leitend mit der ersten Elektrode 12b' des vierten Ladebauelements 9b' verbunden.

Die Vias 11a', 11a" bilden in der nicht gesondert dargestellten Halbleiterschicht und der Isolatorschicht Öffnungen, um eine elektrisch leitende Verbindung zwischen der Source/Drain-Ebene und der Gate-Ebene herstellen zu können.

Die erste Drain-Elektrodenschicht 3a (siehe Figur 2b) des zweiten Feldeffekttransistors 1", welche elektrisch leitend mit der ersten Elektrode 12b' des vierten Ladebauelements 9b' verbunden wird, ist weiterhin über ein Via 11a" mit der Gate-Elektrodenschicht 4 des ersten Feldeffekttransistors 1' bzw. dem Invertereingang 8' des ersten Inverterbauelements 101 elektrisch leitend verbunden. Die erste Drain-Elektrodenschicht 3a (siehe Figur 2b) des ersten Feldeffekttransistors 1', welche elektrisch leitend mit der ersten Elektrode 12b des zweiten Ladebauelements 9b verbunden wird, ist weiterhin über ein Via 11a' mit einem weiteren elektrischen Bauelement elektrisch leitend verbunden.

Da zwischen dem ersten Ladebauelement 9a und dem Feldeffekttransistor 1' sowie zwischen dem Ladebauelement 9a' und dem Feldeffekttransistor 1" anders als in Figur 5 eine elektrisch leitende Verbindung ausgebildet ist, treten hier geringe Leck-Ströme auf.

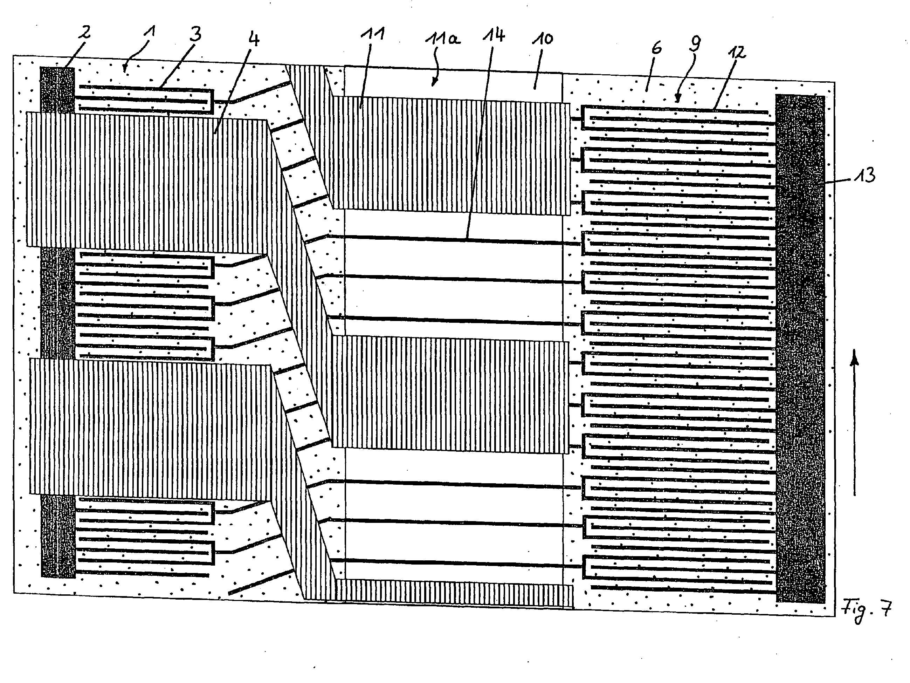

Figur 7 zeigt in Draufsicht ein bevorzugtes Layout für eine gedruckte elektrische Schaltung gemäß Figur 6 auf einem Trägersubstrat 10, wobei in Druckrichtung (siehe Pfeil ganz rechts) eine Vielzahl an Logikbauelementen, umfassend Feldeffekttransistoren 1 und Ladebauelemente 9 in Reihe nacheinander vorgesehen sind. Die elektrische Schaltung weist auf der linken Seite des Trägersubstrats 10 eine Vielzahl von Feldeffekttransistoren 1 auf, welche ähnlich zu Figur 1b auf dem Trägersubstrat 10 mit jeweils einer Source-Elektrodenschicht 2, einer Drain-Elektrodenschicht 3, darauf einer hier nicht sichtbaren Halbleiterschicht und darauf einer Isolatorschicht 6, sowie jeweils einer Gate-Elektrodenschicht 4 auf der Isolatorschicht 6 ausgebildet sind. Die Source-Elektrodenschicht 2 der Feldeffekttransistoren 1 wird an eine erste Versorgungsspannung U₁ angeschlossen. Weiterhin sind nicht angeschlossene Source-/Drain-Bereiche, also nicht von einer Gate-Elektrodenschicht 4 bedeckte Kanalbereiche, zwischen Source- und Drain-Elektrodenschichten 2, 3 erkennbar.

Auf der rechten Seite des Trägersubstrats 10 befinden sich eine Vielzahl von Ladebauelementen 9, welche jeweils eine erste Elektrode 12 und eine zweite Elektrode 13 aufweisen, wobei die zweite Elektrode 13 mit einer zweiten Versorgungsspannung U₂ verbunden wird.

Zur besseren Visualisierung der Lage der diversen Elektrodenschichten 2, 3, 4, 12, 13 zueinander sind hier die unter der Isolatorschicht 6 bzw. unter der Isolatorschicht 6 und gegebenenfalls der Halbleiterschicht angeordneten Elektrodenschichten 2, 3, 12, 13 durch die Isolatorschicht 6 hindurch sichtbar.

Jeweils eine Drain-Elektrodenschicht 3 ist mittels einer Leiterbahn 14 elektrisch leitend mit einer ersten Elektrode 12 eines Ladebauelements verbunden. Zwischen den Feldeffekttransistoren 1 auf der linken Seite und den Ladebauelementen 9 auf der rechten Seite des Trägersubstrats 10 befindet sich in Druckrichtung eine streifenförmige Öffnung, in der keine Halbleiterschicht und keine Isolatorschicht 6 angeordnet ist, sondern das Trägersubstrat 10 mit darauf aufgedruckten Leiterbahnen 14 unmittelbar zu erkennen ist. Diese streifenförmige Öffnung bildet ein Via 11a, in welchem eine elektrisch leitende Verbindung zwischen Leiterbahnen 14 und der auf die Isolatorschicht 6 aufgedruckten Gate-Elektrodenschicht 4 mittels einer Leiterbahn 11 ausgebildet wird. Dabei wird eine elektrisch leitende Verbindung der jeweiligen Gate-Elektrodenschicht 4 zu Ladebauelementen 9 auf der rechten Seite und zu, mit genau diesen Ladebauelementen 9 elektrisch leitend verbundenen Drain-Elektrodenschichten 3 des benachbarten Feldeffekttransistors 1 hergestellt.

Da zwischen allen ersten Elektroden 12 der Ladebauelemente 9 und den Drain-Elektrodenschichten 3 der Feldeffekttransistoren 1 jeweils eine elektrisch leitende Verbindung bzw. Leiterbahn 14 ausgebildet ist, treten hier im Bereich nicht angeschlossener Source-/ Drain-Elektrodenschichten 2, 3 geringe Leck-Ströme auf.

Der erfindungsgemäße Feldeffekttransistor kann somit in unterschiedlichen Formen und Layouts ausgebildet und zur Bildung einer Vielzahl unterschiedlicher Logikbauelemente und elektrischer Schaltungen eingesetzt werden.

## Patentansprüche

1. Verfahren zur Herstellung einer elektrischen Schaltung auf einem Trägersubstrat(10), wobei auf dem Trägersubstrat (10) mindestens ein erstes Bauelement und mindestens ein zweites Bauelement ausgebildet werden, welche elektrisch leitend miteinander verbunden werden,
**dadurch gekennzeichnet,**
**dass** mindestens ein erstes Bauelement in Form eines Feldeffekttransistors (1', 1" , 1"') mit mindestens einer Source-Elektrodenschicht (2) und mindestens einer in gleicher Ebene angeordneten Drain-Elektrodenschicht (3, 3a, 3b, 3c, 3d), einer Halbleiterschicht (5), einer Isolatorschicht (6) sowie einer Gate-Elektrodenschicht (4) ausgebildet wird, wobei die Gate-Elektrodenschicht (4), senkrecht zur Ebene der mindestens einen Source-Elektrodenschicht (2) und der mindestens einen Drain-Elektrodenschicht (3, 3a, 3b, 3c, 3d) gesehen, einen zwischen der mindestens einen Source-Elektrodenschicht (2) und der mindestens einen Drain-Elektrodenschicht (3, 3a, 3b, 3c, 3d) angeordneten Kanal (7) nur teilweise bedeckt, dass mindestens zwei zweite Bauelemente ausgebildet werden, dass mindestens eine Drain-Elektrodenschicht des ersten Bauelements durch Drucken einer Leiterbahn elektrisch leitend mit einer elektrisch leitenden Funktionsschicht eines der mindestens zwei zweiten Bauelemente verbunden wird, wobei das mindestens eine erste Bauelement je nach Registertoleranz beim Drucken der Leiterbahn alternativ mit dem einen oder dem anderen der mindestens zwei zweiten Bauelemente verbunden wird und somit mindestens ein zweites Bauelement ungenutzt verbleibt.

2. Verfahren nach Anspruch 1,
**dadurch gekennzeichnet,**
**dass** die Gate-Elektrodenschicht (4), senkrecht zur Ebene der mindestens einen Source- Elektrodenschicht (2) und der mindestens einen Drain-Elektrodenschicht (3, 3a, 3b, 3c, 3d) gesehen, eine Fläche von 10 bis 90% des Kanals (7) bedeckt.

3. Verfahren nach Anspruch 1,
**dadurch gekennzeichnet,**
**dass** die Gate-Elektrodenschicht (4), senkrecht zur Ebene der mindestens einen Source- Elektrodenschicht (2) und der mindestens einen Drain-Elektrodenschicht (3, 3a, 3b, 3c, 3d) gesehen, eine Fläche von 25 bis 50% des Kanals (7) bedeckt.

4. Verfahren nach einem der Ansprüche 1 bis 3,
**dadurch gekennzeichnet,**
**dass** der Feldeffekttransistor (1, 1', 1", 1"') mindestens eine organische Funktionsschicht umfasst, welche insbesondere durch Drucken gebildet wird.

5. Verfahren nach Anspruch 4,
**dadurch gekennzeichnet,**
**dass** die Halbleiterschicht (5) und/oder die Isolatorschicht (6) als organische Funktionsschicht ausgebildet wird/werden.

6. Verfahren nach einem der vorhergehenden Ansprüche,
**dadurch gekennzeichnet,**
**dass** als zweites Bauelement ein Ladebauelement (9a, 9b; 9a', 9b') ausgebildet wird, welches mindestens eine erste Elektrode (12a, 12b, 12a', 12b') als elektrisch leitende Funktionsschicht und mindestens eine zweite Elektrode (13a, 13b, 13a', 13b') aufweist, wobei die mindestens eine zweite Elektrode (13a, 13b, 13a', 13b') zur Verbindung mit einer Versorgungsspannung ausgebildet wird.

7. Verfahren nach einem der vorhergehenden Ansprüche,
**dadurch gekennzeichnet,**
**dass** die mindestens zwei zweiten Bauelemente in Druckrichtung der Leiterbahn gesehen nacheinander und benachbart zueinander angeordnet werden.

8. Verfahren nach einem der vorhergehenden Ansprüche,
**dadurch gekennzeichnet,**
**dass** mindestens zwei erste Bauelemente ausgebildet werden und dass durch die Leiterbahn eines der ersten Bauelemente mit einem der zweiten Bauelemente elektrisch leitend verbunden wird, so dass mindestens ein erstes Bauelement und mindestens ein zweites Bauelement ungenutzt verbleiben.

9. Verfahren nach Anspruch 8,
**dadurch gekennzeichnet,**
**dass** die mindestens zwei ersten Bauelemente in Druckrichtung der Leiterbahn gesehen nacheinander und benachbart zueinander angeordnet werden.

## Claims

1. Process for the manufacture of an electrical circuit on a carrier substrate (10), in which a first component and at least one second component are formed, which are connected together by electrically conductive means, **characterised in that**,
at least one first component in the form of a field-effect transistor (1', 1" , 1"') with at least one source-electrode layer (2) and at least one drain-electrode layer (3, 3a, 3b, 3c, 3d) arranged in the same plane, a semiconductor layer (5), an insulation layer (6) and also a gate-electrode layer (4) is formed, whereby the gate-electrode layer (4), as seen at right angles to the plane of the at least one source-electrode layer (2) and the at least one drain-electrode layer (3, 3a, 3b, 3c, 3d), only partly covers a channel (7) arranged between the at least one source-electrode layer (2) and the at least one drain-electrode layer (3, 3a, 3b, 3c, 3d),
at least two second components are formed,
at least one drain-electrode layer of the first component is connected with an electrically conductive function layer of one of the at least two second components by means of the printing of a conductor path, whereby the at least one first component is alternatively connected with one or the other of at least two second components, depending on the register tolerance of the printing of the conductor path and thus at least a second component remains unused.

2. Process according to Claim 1,
**characterised in that**,
the gate-electrode layer (4), seen at right angles to the plane of the at least one source-electrode layer (2) and the at least one drain-electrode layer (3, 3a, 3b, 3c, 3d) covers an area of at least 10 to 90% of the channel (7).

3. Process according to Claim 1,
**characterised in that**,
the gate-electrode layer (4), seen at right angles to the plane of the at least one source-electrode layer (2) and the at least one drain-electrode layer (3, 3a, 3b, 3c, 3d), covers an area of 25 to 50% of the channel (7).

4. Process according to one of the Claims 1 to 3,
**characterised in that**,
the field effect transistor (1, 1', 1" , 1"') comprises at least one organic function layer, which in particular is formed by printing.

5. Process according to Claim 4,
**characterised in that**,
the semiconductor layer (5) and/or the insulation layer (6) are/is formed as an organic function layer.

6. Process according to one of the preceding claims,
**characterised in that**,
a charge component (9a, 9b, 9a', 9b') is formed as a second component, which has at least a first electrode (12a, 12b, 12a', 12b') as an electrically-conductive function layer and at least a second electrode (13a, 13b, 13a', 13b'), whereby the at least one second electrode (13a, 13b, 13a', 13b') is formed for connection with a supply voltage.

7. Process according to one of the preceding claims,
**characterised in that**,
as seen in the direction of printing of the conductor path, the at least two second components are arranged one after the other and adjacent to one another.

8. Process according to one of the preceding claims,
**characterised in that**,
at least two first components are formed and that through the conductor path one of the first components is connected by electrical conductive means to one of the second components, such that at least one first component and at least one second component remain unused.

9. Process according to claim 8,
**characterised in that**,
as seen in the direction of printing of the conductor path, the at least two first components are arranged one after the other and adjacent to one another.

## Revendications

1. Procédé pour la fabrication d'un circuit électrique sur un substrat de support (10), au moins un premier composant et au moins un deuxième composant étant formés sur le substrat de support (10), lesquels sont reliés ensemble de manière électroconductrice,
**caractérisé en ce qu'**au moins un premier composant est réalisé sous forme d'un transistor à effet de champ (1', 1" , 1"') avec au moins une couche d'électrode de source (2) et au moins une couche d'électrode de drain (3, 3a, 3b, 3c, 3d) disposée dans le même plan, une couche de semiconducteur (5), une couche d'isolant (6) ainsi qu'une couche d'électrode de grille (4), la couche d'électrode de grille (4), lorsque vue perpendiculairement au plan de l'au moins une couche d'électrode de source (2) et de l'au moins une couche d'électrode de drain (3, 3a, 3b, 3c, 3d) recouvrant seulement partiellement un canal (7) disposé entre l'au moins une couche d'électrode de source (2) et l'au moins une couche d'électrode de drain (3, 3a, 3b, 3c, 3d), au moins deux deuxièmes composants étant réalisés, au moins une couche d'électrode de drain du premier composant étant reliée par impression d'une piste conductrice de manière électroconductrice à une couche fonctionnelle électroconductrice de l'un des au moins deux deuxièmes composants, moyennant quoi l'au moins un premier composant est relié tour à tour selon la tolérance de registre lors de l'impression de la piste conductrice à l'un ou à l'autre des au moins deux deuxièmes composants, au moins un deuxième composant restant ainsi inutilisé.

2. Procédé selon la revendication 1, **caractérisé en ce que** la couche d'électrode de grille (4), lorsque vue perpendiculairement au plan de l'au moins une couche d'électrode de source (2) et de l'au moins une couche d'électrode de drain (3, 3a, 3b, 3c, 3d), recouvre une superficie de 10 à 90% du canal (7).

3. Procédé selon la revendication 1, **caractérisé en ce que** la couche d'électrode de grille (4), lorsque vue perpendiculairement au plan de l'au moins une couche d'électrode de source (2) et de l'au moins une couche d'électrode de drain (3, 3a, 3b, 3c, 3d), recouvre une superficie de 25 à 50% du canal (7).

4. Procédé selon l'une des revendications 1 à 3, **caractérisé en ce que** le transistor à effet de champ (1, 1', 1", 1"') comprend au moins une couche fonctionnelle organique, laquelle est formée en particulier grâce à une impression.

5. Procédé selon la revendication 4, **caractérisé en ce que** la couche de semiconducteur (5) et/ou la couche d'isolant (6) sont réalisées en tant que couche fonctionnelle organique.

6. Procédé selon l'une des revendications précédentes, **caractérisées en ce que** l'on réalise en tant que deuxième composant un composant de charge (9a, 9b ; 9a', 9b'), lequel présente au moins une première électrode (12a, 12b, 12a', 12b') en tant que couche fonctionnelle électroconductrice et au moins une deuxième électrode (13a, 13b, 13a', 13b'), l'au moins une deuxième électrode (13a, 13b, 13a', 13b') étant réalisée pour la liaison avec une tension d'alimentation.

7. Procédé selon l'une des revendications précédentes, **caractérisées en ce que** les au moins deux deuxièmes composants, lorsque vus en direction d'impression de la piste conductrice, sont disposés les uns derrière les autres et de manière contigüe les uns par rapport aux autres.

8. Procédé selon l'une des revendications précédentes, **caractérisé en ce que** l'on réalise au moins deux premiers composants et **en ce que** grâce à la piste conductrice, l'un des premiers composants est relié de manière électroconductrice à l'un des deuxièmes composants, de sorte qu'au moins un premier composant et au moins un deuxième composant restent inutilisés.

9. Procédé selon la revendication 8, **caractérisé en ce que** les au moins deux premiers composants,lorsque vus en direction d'impression de la piste conductrice, sont disposés les uns derrière les autres et de manière contigüe les uns par rapport aux autres.
